(19)

Europäisches
Patentamt
European
Patent Office
Office européen
des brevets

(11) **EP 4 768 954 A1**

(12) **EUROPEAN PATENT APPLICATION**
published in accordance with Art. 153(4) EPC

(43) Date of publication:
**01.07.2026 Bulletin 2026/27**

(21) Application number: **25790748.5**

(22) Date of filing: **06.02.2025**

(51) International Patent Classification (IPC):
**G01R 31/389** (2019.01) **G01R 31/367** (2019.01)
**G01R 31/396** (2019.01) **G01R 27/26** (2006.01)
**G01R 23/02** (2006.01) **H01M 10/48** (2006.01)
**H01M 50/211** (2021.01)

(52) Cooperative Patent Classification (CPC):
**G01R 23/02; G01R 27/26; G01R 31/367;
G01R 31/389; G01R 31/396; H01M 10/48;
H01M 50/211; Y02E 60/10**

(86) International application number:
**PCT/KR2025/099320**

(87) International publication number:
**WO 2025/221123 (23.10.2025 Gazette 2025/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **19.04.2024 KR 20240052764**

(71) Applicant: **LG Energy Solution, Ltd.
Seoul 07335 (KR)**

(72) Inventors:
• **PARK, Ji Hye**
  **Daejeon 34122 (KR)**
• **KIM, Hyeongseok**
  **Daejeon 34122 (KR)**
• **CHO, Hana**
  **Daejeon 34122 (KR)**

(74) Representative: **Plasseraud IP
104 Rue de Richelieu
CS92104
75080 Paris Cedex 02 (FR)**

(54) **METHOD FOR DETERMINING RESISTANCE OF BATTERY CELL AND ELECTRONIC DEVICE FOR PERFORMING SAME**

(57) Disclosed are a method and an electronic device for determining a resistance of a battery cell, the method comprising the steps of: performing EIS analysis of the battery cell according to a plurality of temperatures including a first temperature and a second temperature so as to obtain a chart relating to the impedance of the battery cell according to a change in frequency; extracting a first inductance of the battery cell at the first temperature on the basis of a first graph relating to the impedance of the battery cell at the first temperature; and determining the resistance of the battery cell at the second temperature on the basis of the first inductance, wherein the second temperature is higher than the first temperature.

FIG. 5

## Description

## Technical Field

The present disclosure relates to a method for determining a resistance of a battery cell and an electronic device performing the same.

## Background Art

A pouch-type stack cell corresponds to a type of a battery mounted to most electric vehicles. An electrical resistance component of the pouch-type stack cell, such as an ohmic resistance of a battery cell, is changed due to electrical characteristic of foil and an electrode based on a design. Since various resistance components have influence on output of a battery when an electric vehicle is operated, in order to improve performance of the battery, determining a resistance component of a battery cell and additional analysis based on corresponding resistance components are required.

An impedance measuring method through electrochemical impedance spectroscopy (EIS) analysis is mainly used as a method for determining the resistance component of the battery cell. Also, various researches on a method for determining a resistance so that the resistance is appropriate for various types of battery cells are currently carried out.

## Detailed Description of the Invention

## Technical Goals

Example embodiments of the present disclosure provide a method for determining a resistance of a battery cell and an electronic device performing the same.

Example embodiments of the present disclosure is to accurately measure various types of resistances of the battery cell in consideration of an electric characteristic of a battery changed based on a battery design such as a pouch-type stack cell.

However, the goals to be achieved by example embodiments of the present disclosure are not limited to the objectives described above and other objects may be clearly understood from the following example embodiments.

## Technical solutions

According to an aspect, there is provided a method for determining a resistance of a battery cell, the method including acquiring a chart of an impedance of the battery cell, which is based on a frequency change, by performing electrochemical impedance spectroscopy (EIS) analysis for the battery cell, which is based on a plurality of temperatures including a first temperature and a second temperature, extracting a first inductance of the battery cell at the first temperature based on a first graph of an impedance of the battery cell at the first temperature included in the chart, and determining a resistance of the battery cell at the second temperature based on the first inductance, and the second temperature is a temperature higher than the first temperature.

The determining of the resistance of the battery cell at the second temperature may include determining the first inductance to be a second inductance of the battery cell at the second temperature.

The determining of the resistance of the battery cell at the second temperature may include determining an ohmic resistance of the battery cell at the second temperature based on a value obtained by subtracting a second inductance from an intercept value of a real number impedance axis of a second graph of an impedance of the battery cell at the second temperature, and determining a difference, which is between a resistance at an inflection point of the second graph and the ohmic resistance of the battery cell at the second temperature, to be a charge transfer resistance of the battery cell at the second temperature.

The determining of the ohmic resistance of the battery cell at the second temperature may include acquiring a reference ohmic resistance at the second temperature based on a relationship between the second temperature and the ohmic resistance of the battery cell at the second temperature, and determining, when a difference between the reference ohmic resistance and the ohmic resistance of the battery cell at the second temperature is less than a threshold value, the ohmic resistance of the battery cell at the second temperature based on the value obtained by subtracting the second inductance from an intercept value of the real number impedance axis of the second graph of the impedance of the battery cell at the second temperature.

The method may further include applying a pulse current to the battery cell at the second temperature for a predefined time, and acquiring a final total resistance that is based on a change in a total resistance of the battery cell at the second temperature, which is based on application of the pulse current.

The acquiring of the final total resistance at the second temperature may include acquiring the final total resistance at the second temperature based on a sum of the ohmic resistance of the battery cell at the second temperature, the charge transfer resistance of the battery cell at the second temperature, and a mass transfer resistance of the battery cell at the second temperature.

The battery cell may be a pouch-type stack cell having a structure in which a positive electrode including an active material, a conductive material, and a binder and a negative electrode including graphite, a conductive material, and a binder are stacked.

The second temperature may be a normal temperature, and the first temperature may be a sub-zero temperature.

According to another aspect, there is also provided an electronic device including a memory configured to store an instruction, and a processor connected to the memory, and the processor is configured to acquire a chart of an impedance of a battery cell, which is based on a frequency change, by performing electrochemical impedance spectroscopy (EIS) analysis for the battery cell, which is based on a plurality of temperatures including a first temperature and a second temperature, extract a first inductance of a first graph of an impedance of the battery cell at the first temperature included in the chart, and determine a resistance of the battery cell at the second temperature based on the first inductance, and the second temperature is a temperature higher than the first temperature.

## Effects of the Invention

According to example embodiments, one or more of the following effects may be expected.

According to example embodiments, an electronic device may determine an ohmic resistance and a charge transfer resistance of a battery cell by using a characteristic of an inductance even when visually identifying an ohmic resistance and a charge transfer resistance of the battery cell at a predetermined temperature on a chart of an impedance of the battery cell is difficult due to an inductance component generated in a process of designing the battery cell through electrochemical impedance spectroscopy (EIS) analysis.

In addition, according to example embodiments, the electronic device may verify accuracy of the ohmic resistance of the battery cell determined based on the chart of the impedance of the battery cell and the inductance of the battery cell and may determine additional resistance components such as a mass transfer resistance of the battery cell.

Effects of the present disclosure are not limited to those described above and other effects may be made apparent to those skilled in the art from the following description of the accompanying claims.

## Brief Description of Drawings

FIG. 1 is a diagram for describing a configuration of a system for determining a resistance of a battery cell according to an example embodiment.
FIG. 2 is a diagram for describing an electrochemical impedance spectroscopy (EIS) analysis method according to an example embodiment.
FIG. 3 is a diagram for describing impedance information in which electrochemical impedance spectroscopy (EIS) analysis is performed for each temperature of a subject battery cell according to an example embodiment.
FIG. 4 is a diagram for describing an inductance of a battery cell according to a change in temperature of the subject battery cell according to an example embodiment.
FIG. 5 is a flowchart for describing a method for determining a resistance of a battery cell according to an example embodiment.
FIG. 6 is a diagram for describing a process of acquiring an ohmic resistance of a subject battery cell according to an example embodiment.
FIG. 7 is a diagram for describing a process of acquiring a mass transfer resistance and a total resistance of a subject battery cell according to an example embodiment.
FIG. 8 is a block diagram illustrating an electronic device according to an example embodiment.

## Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

In the present disclosure, a "device" may be implemented as a computer or a portable device capable of accessing a server or another apparatus through a network. The computer may include, for example, a laptop computer, a desktop computer, and a notebook equipped with a web browser. The portable device may be a wireless communication device ensuring a portability and a mobility, and include any type of handheld wireless communication device, for example, a tablet PC, a smartphone, a device based on communication such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

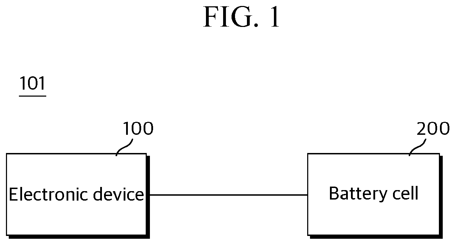

FIG. 1 is a diagram for describing a configuration of a system for determining a resistance of a battery cell according to an example embodiment.

Referring to FIG. 1, a system 101 may be in conjunction with an electronic device 100 measuring a resistance of a battery cell 200. In this case, the battery cell 200 may be a pouch-type stack cell having a structure in which a positive electrode including an active material, a conductive material, and a binder and a negative electrode including graphite, a conductive material, and a binder are stacked. Alternatively, the battery cell 200 may be a pouch-type cell, a cylindrical cell, and a prismatic cell. Meanwhile, particular elements, which are associated with the present example embodiment, are illustrated in FIG. 1. Thus, those skilled in the art associated with the present example embodiment may understand that other elements in general use in addition to the elements illustrated in FIG. 1 may be further included.

The electronic device 100 may include one or more sensors for measuring a parameter including electrical conductance of the above-described battery cell 200 which is a subject of resistance determination, and the electronic device 100 may include a memory and a processor (not illustrated) for various operations. In other words, the electronic device 100 may perform an operation of acquiring a chart of an impedance of the battery cell 200, which is based on a frequency change, by performing electrochemical impedance spectroscopy (EIS) analysis for the battery cell 200, which is based on a plurality of temperatures. In this case, the chart of the impedance of the battery cell 200 may correspond to, for example, a Nyquist plot chart.

According to an example embodiment, the battery cell 200 may correspond to a battery cell of which a positive electrode including an active material, a binder, and a conductive material and a negative electrode including graphite, a binder, and a conductive material are impregnated with an electrolyte. For example, the battery cell 200 may correspond to the pouch-type stack cell having the structure in which the positive electrode including the active material, the conductive material, and the binder and the negative electrode including the graphite, the conductive material, and the binder are stacked. Specifically, the battery cell 200 may correspond to a pouch-type cell having a form in which nineteen positive electrode/negative electrode cells having a width of approximately 90 millimeters (mm) and a length of 258 mm are stacked.

For example, masses of the active material, the binder, and the conductive material may account for 97.5%, 1.5%, and 1%, respectively, of a total mass of an active material layer including the active material, the binder, and the conductive material. Accordingly, the positive electrode may correspond to a positive electrode of which a content of a conductive material is 1% of an entire active material layer of the electrode. For example, masses of the graphite, the binder, and the conductive material may account for 95%, 3.5%, and 1.5%, respectively, of a total mass of the graphite, the binder, and the conductive material. Accordingly, the negative electrode may correspond to a subject negative electrode of which a content of a conductive material is 1.5% of the entire active material layer of the subject electrode. For example, the battery cell 200 may be impregnated with an electrolyte into which ethylene carbonate (EC) and ethyl methyl carbonate (EMC) are mixed in a ratio of three to seven and to which one mole of lithium hexafluorophosphate (LiPF6) is added. However, a type of the battery cell 200 in a method for determining the resistance of the battery cell 200 according to the present disclosure is not limited to the above-mentioned case. Example embodiments of the present disclosure may include, for example, the battery cell 200 which has various forms such as the cylindrical cell and the prismatic cell as well as the pouch-type stack cell, may include various types of the positive electrode and the negative electrode, and may include various types of the electrolyte.

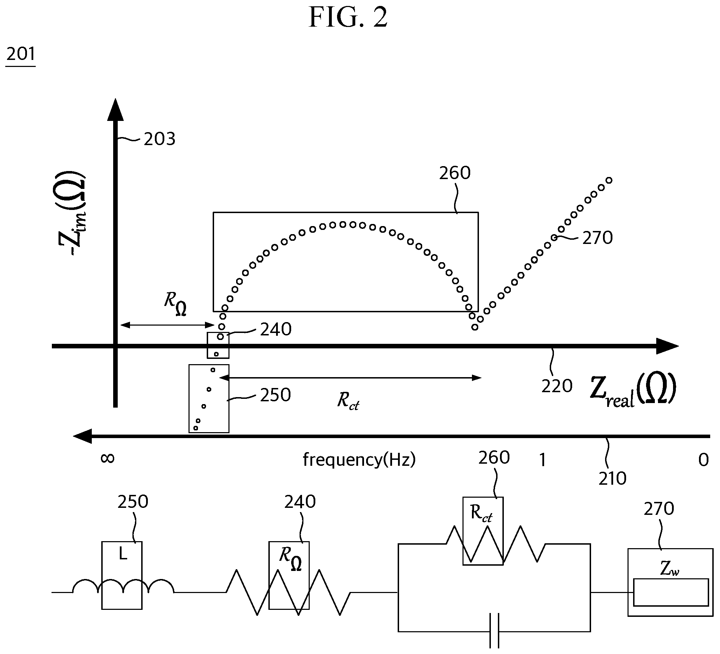

FIG. 2 is a diagram for describing an electrochemical impedance spectroscopy (EIS) analysis method according to an example embodiment.

Referring to FIG. 2, a concept of EIS used to determine a resistance of a battery cell may be identified. Impedance spectroscopy may be a method of interpreting a Nyquist plot chart 201 acquired by dividing, by a real number impedance 220 and an imaginary number impedance 230, impedance information acquired by constantly changing a frequency 210 of an alternating current (AC) power source and applying the frequency 210 to the battery cell 200. Here, the Nyquist plot chart 201 may be a chart for evaluating stability of a system through a parameter plot of a frequency response used in automated control and signal processing. The Nyquist plot chart 201 may be a chart that visualizes, on a complex plane including an axis of a real number component and an axis of an imaginary number component, a graph showing a response according to a frequency change in the system. A Nyquist plot chart of an impedance of the battery cell 200 according to an example embodiment may be, for example, a chart that visualizes a graph, which shows the impedance of the battery cell 200 based on a frequency change in an alternating current by applying the alternating current to the battery cell 200 at each of a plurality of temperatures, on the complex plane including the axis of the real number component and the axis of the imaginary number component.

In the impedance spectroscopy, interpreting an electrochemical process of the Nyquist plot in association with impedance analysis for the battery cell 200 may be associated with analyzing a plurality of areas on the Nyquist plot. For example, an area 240 including an intercept value of an axis of the real number component 220 of the impedance information may be used to analyze ohmic resistance associated with a characteristic of electrolyte ion conductivity of electrolyte resistance of the battery cell 200 and a characteristic of external electrolyte resistance.

For example, a negative area 250 of an axis of the imaginary number impedance 230 of the impedance information acquired based on a change in the frequency 210 may be used to analyze information on an inductance component that is parasitic on the battery cell 200. Hereinafter, as described below, in a pouch-type stack cell, the inductance component may correspond to a resistance component generated due to an electrical characteristic varying depending on a design of the battery cell 200.

For example, a second semicircle area 260 of the impedance information acquired based on the change in the frequency 210 may be used to analyze charge transfer impedance information showing a lithium-ion oxidation-reduction reaction on an electrode material interface by charge transfer resistance (denoted by $R_{CT}$) that is a phenomenon occurring when a charge is moved on an electrode surface/interface of the battery cell 200. Accordingly, information on a charge transfer resistance of the battery cell 200 may be acquired. For example, a linear area 270 acquired based on the change in the frequency 210 may include Warburg impedance information acquired in a low-frequency area and may be used to analyze diffusion of a lithium ion (Li ion) associated with chemical diffusion resistance of the lithium ion by inter-layer insertion into a particle crystal structure in the battery cell 200.

The electronic device 100 according to the present disclosure may acquire the impedance of the battery cell 200, which is based on the change in the frequency 210, by performing EIS analysis for the battery cell 200, which is based on a plurality of temperatures (e.g., -30 degrees Celsius (°C) -20 °C, 0 °C, and 25 °C). For example, in a case of the pouch-type stack cell, the area 240 which includes the intercept value of the axis of the real number impedance 220 of the impedance information and the negative area 250 of the axis of the imaginary number impedance 230 of the impedance information may mingle depending on the inductance component which appears due to the electrical characteristic varying depending on the design of the battery cell 200. Accordingly, accurately identifying a resistance of the battery cell 200 may be difficult. Hereinafter, a method for determining, in consideration of a characteristic of the inductance component and inductance components at the plurality of temperatures, an ohmic resistance of the battery cell 200 by using the characteristic and determining the charge transfer resistance, a mass transfer resistance, and a total resistance will be identified in detail.

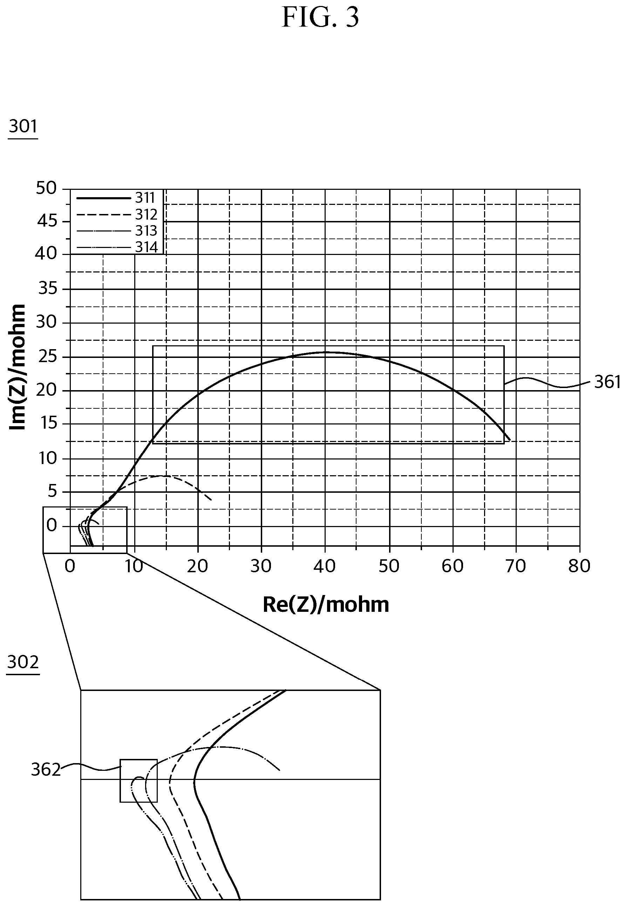

FIG. 3 is a diagram for describing impedance information in which electrochemical impedance spectroscopy (EIS) analysis is performed for each temperature of a subject battery cell according to an example embodiment.

Referring to FIG. 3, the electronic device 100 according to an example embodiment may acquire a chart 401 of an impedance of the battery cell, which is based on a frequency change, by performing the electrochemical impedance spectroscopy (EIS) analysis for the battery cell, which is based on a plurality of temperatures including a first temperature and a second temperature. For example, the electronic device 100 may acquire a Nyquist plot chart by using the chart 301 on the impedance of the battery cell and acquire a plurality of graphs of impedances of the battery cell 200, which are based on the plurality of temperatures included in the chart 301 (e.g., a first graph 311, a second graph 312, a graph 313, and a graph 314). Hereinafter, a case in which the first graph 311 of an impedance of the battery cell 200, which is based on a frequency change at the first temperature which corresponds to a relatively low temperature (e.g., -30 °C), is acquired and the second graph 312, the graph 313, and the graph 314 of impedances of the battery cell 200, which are based on frequency changes at the second temperature which corresponds to temperatures higher than the first temperature (e.g., -20 °C, 0 °C, and 25 °C), are acquired will be described as a reference.

Referring to the second graph 312, the graph 313, and the graph 314, it may be understood that a size of a semicircle area of impedance information acquired according to the frequency change of the first graph 311 is larger than a size of a semicircle area of impedance information acquired according to a frequency change of each of the second graph 312, the graph 313, and the graph 314 and that an ohmic resistance of each of the second graph 312, the graph 313, and the graph 314 are not clearly identified due to an influence by inductance. In other words, when the battery cell 200 is a pouch-type stack cell, as described with reference to FIG. 3, clearly identifying an ohmic resistance through analysis of an area including an intercept value of an imaginary number impedance axis of a graph may be difficult due to an inductance of the battery cell 200. This may be identified through the second graph 312, the graph 313, and the graph 314 of a chart 302 showing an enlargement of an associated area of the chart 301. Particularly, in a case of an area 362 including an intercept value of a real number impedance axis of the second graph 312 at a normal temperature, it may be identified that distinguishing an area including an intercept value of a real number impedance axis of impedance information on the Nyquist plot described above with reference to FIG. 2, a negative area of an axis of an imaginary number impedance axis of the impedance information, and a semicircle area acquired according to the frequency change is difficult due to an influence by a second inductance component of the battery cell 200 at the second temperature even on the chart 302 showing the enlargement. Specifically, since the intercept value of the real number impedance axis of the second graph of the impedance of the battery cell 200 at the second temperature and the second inductance component have mingled, it may be identified that clearly separating and analyzing an ohmic resistance of the battery cell 200 at the second temperature and a second inductance of the battery cell 200 at the second temperature is difficult.

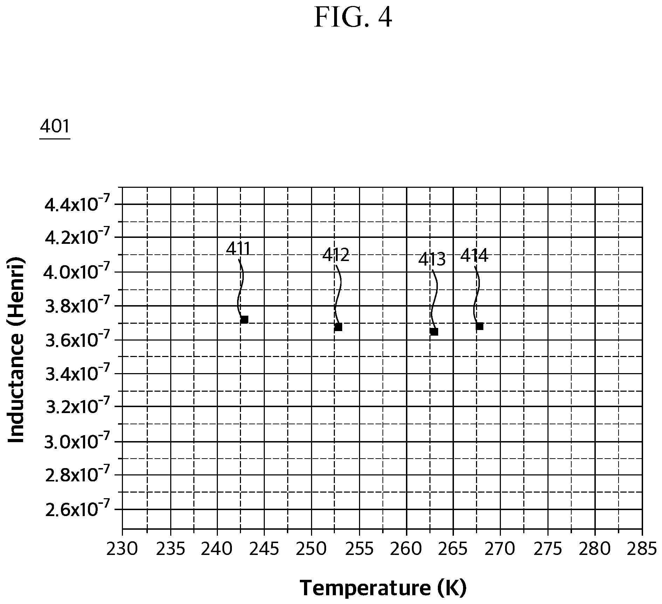

FIG. 4 is a diagram for describing an inductance of a battery cell according to a change in temperature of the battery cell according to an example embodiment.

Referring to FIG. 4, inductances 411, 412, 413, and 414 of the battery cell 200 individually at a plurality of temperatures may be identified through an inductance chart 401 based on a change in temperature of the battery cell 200. Since separation of an ohmic resistance and an inductance of a small cell is easy because the inductance at a time of measuring an impedance is not large, the battery cell 200 in this case may correspond to the small cell in consideration thereof. The inductances 411, 412, 413, and 414 of the battery cell 200 may be measured with a small mono-cell corresponding to an area of approximately 12 square centimeters ( $cm^2$ ) as a reference. As identifiable with reference to FIG. 4, an inductance 411 at a temperature of approximately 243 kelvins (K), an inductance 412 at a temperature of approximately 253 K, an inductance 413 at a temperature of 263 K, and an inductance 414 at a temperature of approximately 273 K all may be identified as having values within a range approximately from $3.8 \times 10^{-7}$ henries (H) to $3.6 \times 10^{-7}$ H. That is, it may be identified that a difference between inductances of the battery cell 200, which is based on a change in temperature, is not large and that an inductance thereof is constantly maintained. This may be understood as that an inductance component corresponding to an electrical characteristic generated due to a structural characteristic of the battery cell 200 is not greatly changed because the structural characteristic of the battery cell 200 is not greatly changed even if a temperature of the battery cell 200 is changed. In other words, through this, the electronic device 100 according to an example embodiment may acquire an inductance component at a predetermined temperature of a predetermined battery cell 200 and then determine a value of the inductance component to be an inductance value at another temperature of the identical battery cell 200.

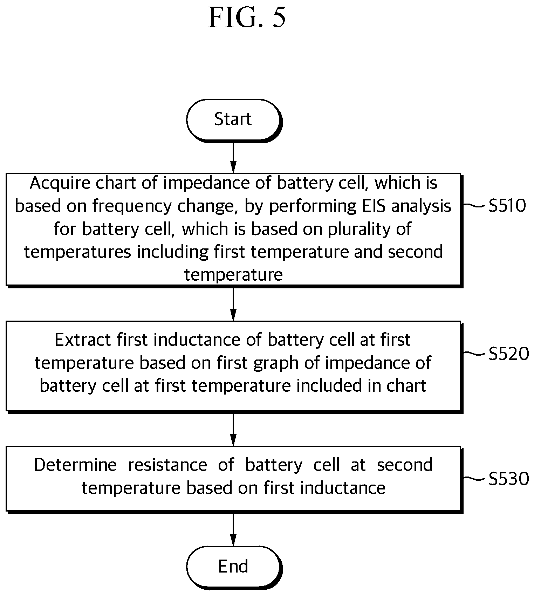

FIG. 5 is a flowchart for describing a subject electrode measuring method according to an example embodiment.

As described above with reference to FIG. 3, in a case of a pouch-type stack cell, since a size of a semicircle area of impedance information acquired based on a frequency change at a predetermined temperature (e.g., -20 °C, 0 °C, or 25 °C) is smaller than a size of a semicircle area of impedance information acquired at a temperature lower (e.g., -30 °C) than the predetermined temperature. Also, due to an inductance component, clearly identifying an ohmic resistance through analysis of an area including an intercept value of a real number impedance axis of a graph is difficult. However, by using a fact that a difference between inductances of the battery cell 200 based on a change in temperature is not large as described above with reference to FIG. 4, a method for determining a resistance of the battery cell 200 according to the present disclosure will be described below with reference to FIG. 5.

Referring to FIG. 5, in operation S510, the electronic device 100 according to an example embodiment may acquire a chart of an impedance of the battery cell 200, which is based on a frequency change, by performing EIS analysis for the battery cell 200, which is based on a plurality of temperatures including a first temperature and a second temperature. As described above, the chart of the impedance of the battery cell 200, which is based on the frequency change, may correspond to a Nyquist plot chart. In this case, as described above, the first temperature may correspond to a sub-zero temperature of approximately -30 °C, and the second temperature may be a temperature higher than the first temperature and correspond to a normal temperature of, for example, approximately 25 °C. The electronic device 100 according to an example embodiment may acquire the chart of the impedance of the battery cell 200, which is based on the frequency change, through the impedance analysis described above with reference to FIG. 2 and acquire graphs of impedances of the battery cell 200 at the plurality of temperatures including the first temperature and the second temperature as described above with reference to FIG. 3.

The electronic device 100 according to an example embodiment may extract a first inductance of a first graph of an impedance of the battery cell 200 at the first temperature in operation S520. As described above with reference to FIG. 3, the first graph of the impedance of the battery cell 200 at the first temperature may correspond to a graph with which extracting the first inductance through analysis of a negative area of an imaginary number impedance axis of impedance information acquired based on a frequency change is allowed because the graph has a semicircle area of the impedance information larger than those of graphs on impedances of the battery cell 200 at other temperatures.

The electronic device 100 according to an example embodiment may determine resistances of the battery cell 200 at the second temperature based on the first inductance in operation S530. As described with reference to FIG. 4, since an inductance of the battery cell 200 does not largely vary depending on a temperature change and is maintained approximately constantly, the electronic device 100 according to an example embodiment may determine the first inductance to be a second inductance of the battery cell 200 at the second temperature.

The electronic device 100 according to an example embodiment may determine an ohmic resistance of the battery cell 200 at the second temperature based on a value obtained by subtracting the second inductance from an intercept value of a real number impedance axis of a second graph of an impedance of the battery cell 200 at the second temperature. As described above with reference to FIG. 3, since the ohmic resistance and an inductance component has mingled in an area including the intercept value of the real number impedance axis of the second graph 312 at the second temperature, the electronic device 100 may remove an influence by the inductance and separate the ohmic resistance at the second temperature through determination of the ohmic resistance of the battery cell 200 at the second temperature based on the value obtained by subtracting the second inductance from the intercept value of the real number impedance axis of the second graph. The electronic device 100 according to an example embodiment may determine a difference, which is between a resistance at an inflection point of the second graph and the ohmic resistance of the battery cell 200 at the second temperature, to be a charge transfer resistance of the battery cell 200 at the second temperature.

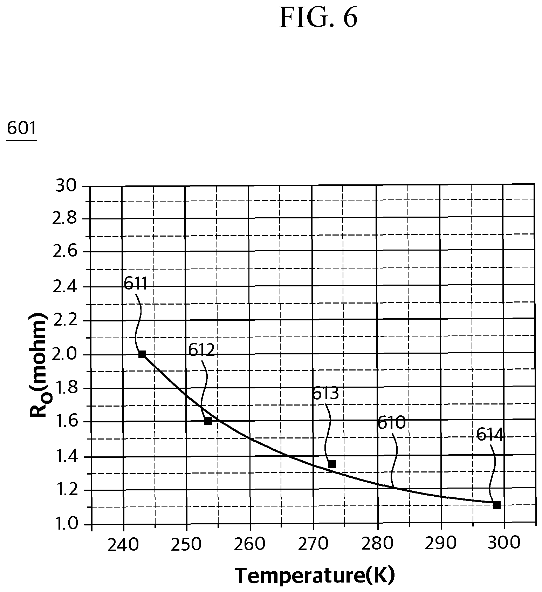

In order to verify whether a value of the ohmic resistance acquired as such is valid, the electronic device 100 according to an example embodiment may acquire a reference ohmic resistance at the second temperature based on a relationship between the second temperature and the ohmic resistance of the battery cell 200 at the second temperature and determine, when a difference between the reference ohmic resistance and the ohmic resistance of the battery cell 200 at the second temperature is less than a threshold value, the ohmic resistance of the battery cell 200 at the second temperature based on the value obtained by subtracting the second inductance from the intercept value of the real number impedance axis of the second graph of the impedance of the battery cell 200 at the second temperature. In other words, the electronic device 100 according to an example embodiment may acquire, based on an Arrhenius equation, the reference ohmic resistance which includes information on a tendency for the ohmic resistance to change with the temperature change and may compare the reference ohmic resistance and the ohmic resistance acquired according to the present disclosure to verify whether the acquired ohmic resistance is an accurate value. Details thereof will be described below with reference to FIG. 6.

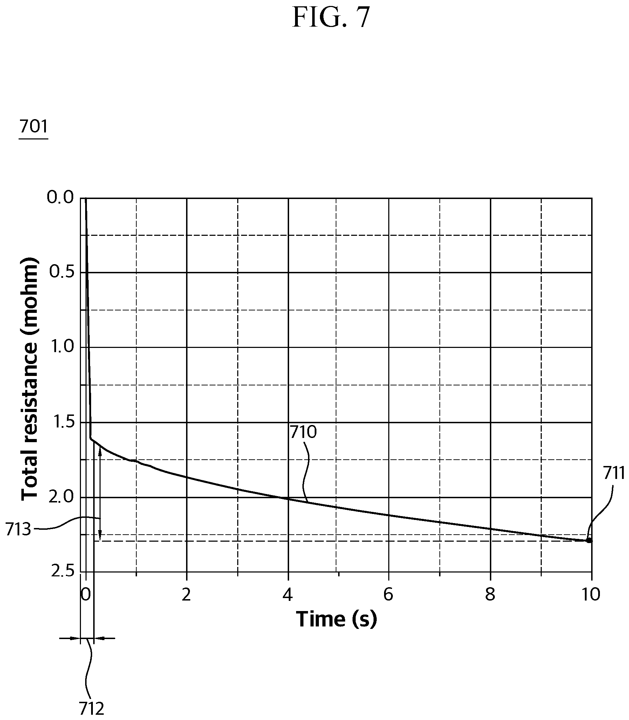

After acquiring the inductance of the battery cell 200, the ohmic resistance of the battery cell 200, and the charge transfer resistance of the battery cell 200 at the second temperature through the above-described operation, the electronic device 100 according to an example embodiment may determine an additional resistance component of the battery cell 200 by applying a pulse current to the battery cell 200 at the second temperature for a predefined time. For example, the electric device 100 according to an example embodiment may acquire a final total resistance, which is based on a change in a total resistance of the battery cell 200 at the second temperature based on application of the pulse current. In this case, the final total resistance at the second temperature may be acquired based on a sum of the ohmic resistance of the battery cell 200 at the second temperature, the charge transfer resistance of the battery cell 200 at the second temperature, and a mass transfer resistance of the battery cell 200 at the second temperature. Details thereof will be described below with reference to FIG. 7.

FIG. 6 is a diagram for describing a process of acquiring an ohmic resistance of a subject battery cell according to an example embodiment.

As described above with reference to FIG. 5, after determining an ohmic resistance of the battery cell 200 according to the present disclosure, the electronic device 100 according to an example embodiment may compare the ohmic resistance to a reference ohmic resistance determined based on the Arrhenius equation.

Referring to FIG. 6, the electronic device 100 according to an example embodiment may acquire an reference ohmic resistance at a second temperature based on the Arrhenius equation. In this case, the reference ohmic resistance may correspond to a resistance acquired based on a relationship between an absolute temperature and a resistance according to the Arrhenius equation and correspond to a resistance that is a reference for verifying whether an ohmic resistance of a battery cell of the present disclosure, which is acquired according to a method of determining a resistance of the battery cell in the present disclosure according to an example embodiment, is within an appropriate range. In this case, the Arrhenius equation may be defined as, for example, the following equation.

[Equation 1]

$$\mathrm{K} = \mathrm{A}\,X\,e^{-\frac{E_a}{RT}}$$

In this case, "K" may denote a speed constant. "A" may denote a frequency coefficient. "R" may denote a gas constant. "T" may denote an absolute temperature. "$E_a$" may denote activation energy. That is, according to the Arrhenius equation, a speed of a chemical reaction is faster when an absolute temperature of a system in which the chemical reaction occurs is increased. When this is interpreted in terms of the battery cell 200, it may be considered that a relationship in which movement of electrons is facilitated is present. That is, according to the Arrhenius equation, when a temperature of the battery cell 200 is increased, the ohmic resistance of the battery cell 200 may be decreased to correspond thereto. For example, as identifiable through Equation 1, the electronic device 100 according to an example embodiment may acquire the reference ohmic resistance at the second temperature based on a relationship in which an ohmic resistance of the battery cell 200 at the second temperature is decreased as the second temperature is increased. Specifically, in a reference ohmic resistance chart 601 based on the Arrhenius equation according to a temperature change, the reference ohmic resistance based on the Arrhenius equation may be acquired as shown in a graph 610.

When a difference between the reference ohmic resistance and the ohmic resistance of the battery cell 200 at the second temperature is less than a threshold value, the electronic device 100 according to an example embodiment may determine the ohmic resistance of the battery cell 200 at the second temperature based on a value obtained by subtracting a second inductance from an intercept value of a real number impedance axis of a second graph of an impedance of the battery cell 200 at the second temperature. Specifically, for example, the electronic device 100 according to an example embodiment may compare values 611, 612, 613, and 614, which are values obtained, with reference to FIG. 5, by subtracting inductances from an intercept value of a real number impedance axis of a graph of an impedance of the battery cell 200 at predetermined temperatures, with a reference ohmic resistance of the graph 610 based on the Arrhenius equation at an equal temperature as a reference. When corresponding differences are less than a threshold value, the values 611, 612, 613, and 614 may be determined to be the ohmic resistance of the battery cell 200. In conclusion, the electronic device 100 according to an example embodiment may further strictly determine the ohmic resistance of the battery cell 200 through comparison with the reference ohmic resistance based on the Arrhenius equation which is associated with a resistance change based on a temperature in addition to determining a value obtained by subtracting the inductance from the intercept value of the real number impedance axis of the graph of the impedance of the battery cell 200. Similarly, the electronic device 100 according to an example embodiment may perform an identical process for a charge transfer resistance of the battery cell 200 to further strictly determine the charge transfer resistance of the battery cell 200.

FIG. 7 is a diagram for describing a process of acquiring a mass transfer resistance and a total resistance of a subject battery cell according to an example embodiment.

Referring to FIG. 7, through a resistance chart 701 of the battery cell 200 to which a pulse current is applied, a change in a total resistance of the battery cell may be identified. The electronic device 100 according to an example embodiment may apply the pulse current to the battery cell 200 at a second temperature for a predefined time and acquire a final total resistance 711 according to a change in a total resistance of the battery cell 200 at the second temperature based on application of the pulse current. In this case, the final total resistance 711 may be acquired based on a sum of an ohmic resistance of the battery cell 200 at the second temperature, a charge transfer resistance of the battery cell 200 at the second temperature, and a mass transfer resistance of the battery cell 200 at the second temperature. Specifically, the electronic device 100 according to an example embodiment may apply the pulse current to the battery cell 200 for the predefined time (e.g., 10 seconds) and determine a variance, which is in the total resistance of the battery cell 200 within an interval 712 in which a rate of a change in the total resistance of the battery cell 200 over time is greater than or equal to a threshold value, to be a sum of the ohmic resistance at the second temperature and the charge transfer resistance of the battery cell 200 at the second temperature. In other words, a variance in the total resistance 711 within the interval 712 after the application of the pulse current to the battery cell 200 may be defined as the sum of the ohmic resistance at the second temperature and the charge transfer resistance of the battery cell 200 at the second temperature. The electronic device 100 according to an example embodiment may determine a difference, which is between a total resistance value after the interval 712 and the final total resistance 711 at a final time point at which the application of the pulse current ends, to be the mass transfer resistance at the second temperature. In other words, the final total resistance 711 at the second temperature may be defined as the sum of the ohmic resistance of the battery cell 200 at the second temperature, the charge transfer resistance of the battery cell 200 at the second temperature, and a mass transfer resistance 713 of the battery cell 200 at the second temperature. In conclusion, after acquiring an ohmic resistance and a charge transfer resistance of the battery cell 200 at a predetermined temperature, the electronic device 100 according to an example embodiment may acquire a mass transfer resistance and a final total resistance of the battery cell 200 at the predetermined temperature through application of a pulse current for a predefined time.

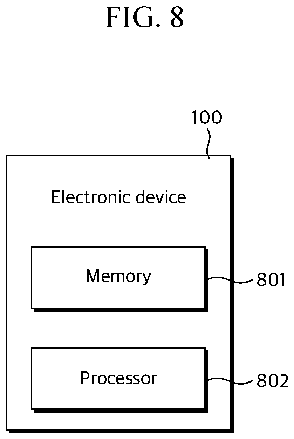

FIG. 8 is a block diagram illustrating an electronic device according to an example embodiment.

Referring to FIG. 8, the electronic device 100 according to an example embodiment may include a processor 801 and a processor 802. Particular elements, which are associated with the present example embodiment, are illustrated with respect to the electronic device 100 which is illustrated in FIG. 6. Thus, those skilled in the art associated with the present example embodiment may understand that other elements in general use in addition to the elements illustrated in FIG. 6 may be further included. In an example embodiment, the processor 802 may be included in a controller.

The processor 802 may control overall operations of the electronic device 100 and process data and a signal. The processor 802 may be formed of at least one hardware unit. In addition, the processor 802 may be operated by one or more software modules generated by executing program code stored in the memory 801. Since the processor 802 may include a memory, the processor 802 may control the overall operations of the electronic device 100 and process the data and the signal by executing program code stored in the memory.

The processor 802 may acquire a chart of an impedance of the battery cell 200, which is based on a frequency change, by performing EIS analysis for the battery cell 200, which is based on a plurality of temperatures including a first temperature and a second temperature, extract a first inductance of a first graph of an impedance of the battery cell 200 at the first temperature included in the chart, and determine a resistance of the battery cell 200 at the second temperature based on the first inductance. In this case, the second temperature may correspond to a temperature higher than the first temperature, and the processor 802 may determine resistances including an ohmic resistance and a charge transfer resistance of the battery cell 200 at various temperatures based on a characteristic of an inductance of the battery cell 200 described above.

In some example embodiments, the electronic device 100 may additionally include a transceiver for performing wired/wireless communication. The electronic device 100 may communicate with an external electronic device (e.g., an electronic device 100) by using the transceiver. The external electronic device may be a terminal or a server. Also, a communication technology used by the transceiver may include Global System for Mobile communication (GSM), Code Division Multi Access (CDMA), Long Term Evolution (LTE), 5th Generation (5G), a wireless local area network (WLAN), Wireless-Fidelity (Wi-Fi), Bluetooth, radio frequency identification (RFID), infrared data association (IrDA), ZigBee, near field communication (NFC), or the like.

The server according to the above-described example embodiments may include a processor, a memory that stores and executes program data, a permanent storage such as a disk drive, a communication port for communicating with an external device, and a user interface device such as a touch panel, a key, and an button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor.

The above-described embodiments are merely examples and other embodiments may be implemented within the scope of the following claims.

## Claims

1. A method for determining a resistance of a battery cell, the method comprising:

   acquiring a chart of an impedance of the battery cell, which is based on a frequency change, by performing electrochemical impedance spectroscopy (EIS) analysis for the battery cell, which is based on a plurality of temperatures including a first temperature and a second temperature; extracting a first inductance of the battery cell at the first temperature based on a first graph of an impedance of the battery cell at the first temperature included in the chart; and determining a resistance of the battery cell at the second temperature based on the first inductance, wherein the second temperature is a temperature higher than the first temperature.

2. The method of claim 1, wherein the determining of the resistance of the battery cell at the second temperature comprises determining the first inductance to be a second inductance of the battery cell at the second temperature.

3. The method of claim 1, wherein the determining of the resistance of the battery cell at the second temperature comprises:

   determining an ohmic resistance of the battery cell at the second temperature based on a value obtained by subtracting a second inductance from an intercept value of a real number impedance axis of a second graph of an impedance of the battery cell at the second temperature; and determining a difference, which is between a resistance at an inflection point of the second graph and the ohmic resistance of the battery cell at the second temperature, to be a charge transfer resistance of the battery cell at the second temperature.

**4.** The method of claim 3, wherein the determining of the ohmic resistance of the battery cell at the second temperature comprises:

acquiring a reference ohmic resistance at the second temperature based on a relationship between the second temperature and the ohmic resistance of the battery cell at the second temperature; and

determining, when a difference between the reference ohmic resistance and the ohmic resistance of the battery cell at the second temperature is less than a threshold value, the ohmic resistance of the battery cell at the second temperature based on the value obtained by subtracting the second inductance from an intercept value of the real number impedance axis of the second graph of the impedance of the battery cell at the second temperature.

**5.** The method of claim 1, further comprising:

applying a pulse current to the battery cell at the second temperature for a predefined time; and acquiring a final total resistance that is based on a change in a total resistance of the battery cell at the second temperature, which is based on application of the pulse current.

**6.** The method of claim 5, wherein the acquiring of the final total resistance at the second temperature comprises acquiring the final total resistance at the second temperature based on a sum of the ohmic resistance of the battery cell at the second temperature, the charge transfer resistance of the battery cell at the second temperature, and a mass transfer resistance of the battery cell at the second temperature.

**7.** The method of claim 1, wherein the battery cell is a pouch-type stack cell having a structure in which a positive electrode including an active material, a conductive material, and a binder and a negative electrode including graphite, a conductive material, and a binder are stacked.

**8.** The method of claim 1, wherein the second temperature is a normal temperature, and the first temperature is a sub-zero temperature.

**9.** A non-transitory computer-readable recording medium in which a program for executing the method of any one of claims 1 through 8 in a server is recorded.

**10.** An electronic device comprising:

a memory configured to store an instruction; and a processor connected to the memory, wherein the processor is configured to:

acquire a chart of an impedance of a battery cell, which is based on a frequency change, by performing electrochemical impedance spectroscopy (EIS) analysis for the battery cell, which is based on a plurality of temperatures including a first temperature and a second temperature;

extract a first inductance of a first graph of an impedance of the battery cell at the first temperature included in the chart; and determine a resistance of the battery cell at the second temperature based on the first inductance, and

the second temperature is a temperature higher than the first temperature.

# FIG. 1

<u>101</u>

100

200

| Electronic device | | Battery cell |

# FIG. 2

EP 4 768 954 A1

# FIG. 3

# FIG. 4

401

# FIG. 5

Start

Acquire chart of impedance of battery cell, which is based on frequency change, by performing EIS analysis for battery cell, which is based on plurality of temperatures including first temperature and second temperature — S510

Extract first inductance of battery cell at first temperature based on first graph of impedance of battery cell at first temperature included in chart — S520

Determine resistance of battery cell at second temperature based on first inductance — S530

End

# FIG. 6

<u>601</u>

# FIG. 7

# FIG. 8

## INTERNATIONAL SEARCH REPORT

| International application No. |
| --- |
| **PCT/KR2025/099320** |

| A. | CLASSIFICATION OF SUBJECT MATTER |
| --- | --- |

**G01R 31/389**(2019.01)i; **G01R 31/367**(2019.01)i; **G01R 31/396**(2019.01)i; **G01R 27/26**(2006.01)i; **G01R 23/02**(2006.01)i; **H01M 10/48**(2006.01)i; **H01M 50/211**(2021.01)i

According to International Patent Classification (IPC) or to both national classification and IPC

| B. | FIELDS SEARCHED |
| --- | --- |

Minimum documentation searched (classification system followed by classification symbols)

G01R 31/389(2019.01); G01R 31/36(2006.01); G01R 31/382(2019.01); G06F 17/18(2006.01); H01M 10/48(2006.01); H01M 50/10(2021.01); H01M 50/20(2021.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 셀(battery cell), 저항(resistance), 온도(temperature), EIS(electrical impedance spectroscopy)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | KR 10-2581184 B1 (MINTECH CO., LTD.) 21 September 2023 (2023-09-21) See paragraphs [0051]-[0071], claim 1 and figures 1-7. | 1-2,7-10 |
| A | | 3-6 |
| Y | KR 10-2020-0117794 A (LG CHEM, LTD.) 14 October 2020 (2020-10-14) See paragraphs [0063]-[0064] and figures 1-10. | 1-2,7-10 |
| Y | KR 10-2021-0114592 A (SAMSUNG ELECTRONICS CO., LTD.) 24 September 2021 (2021-09-24) See paragraphs [0042] and [0072]-[0074] and figures 4a-9b. | 7 |
| A | KR 10-2022-0043640 A (LG ENERGY SOLUTION, LTD.) 05 April 2022 (2022-04-05) See claims 1-12 and figures 1-7. | 1-10 |

☑ Further documents are listed in the continuation of Box C.    ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **30 April 2025** | **01 May 2025** |

| Name and mailing address of the ISA/KR | Authorized officer |
| --- | --- |
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2025/099320**

**C. DOCUMENTS CONSIDERED TO BE RELEVANT**

| Category* | Citation of document, with indication, where appropriate, of the relevant passages | Relevant to claim No. |
|---|---|---|
| A | CN 114814621 A (ZHONGTIAN ENERGY STORAGE TECHNOLOGY CO., LTD.) 29 July 2022 (2022-07-29)<br>See claims 1-10 and figures 1-11. | 1-10 |

## INTERNATIONAL SEARCH REPORT
### Information on patent family members

International application No.

**PCT/KR2025/099320**

| Patent document cited in search report | | | Publication date (day/month/year) | Patent family member(s) | | | Publication date (day/month/year) |
|---|---|---|---|---|---|---|---|
| KR | 10-2581184 | B1 | 21 September 2023 | None | | | |
| KR | 10-2020-0117794 | A | 14 October 2020 | CN | 112602226 | A | 02 April 2021 |
| | | | | CN | 112602226 | B | 06 February 2024 |
| | | | | EP | 3876334 | A1 | 08 September 2021 |
| | | | | EP | 3876334 | A4 | 19 January 2022 |
| | | | | EP | 3876334 | B1 | 04 December 2024 |
| | | | | JP | 2022-502815 | A | 11 January 2022 |
| | | | | JP | 7063440 | B2 | 09 May 2022 |
| | | | | KR | 10-2768452 | B1 | 13 February 2025 |
| | | | | US | 12123914 | B2 | 22 October 2024 |
| | | | | US | 2022-0221516 | A1 | 14 July 2022 |
| | | | | WO | 2020-204584 | A1 | 08 October 2020 |
| KR | 10-2021-0114592 | A | 24 September 2021 | WO | 2021-182814 | A1 | 16 September 2021 |
| KR | 10-2022-0043640 | A | 05 April 2022 | CN | 115667963 | A | 31 January 2023 |
| | | | | EP | 4141461 | A1 | 01 March 2023 |
| | | | | EP | 4141461 | A4 | 20 December 2023 |
| | | | | EP | 4141461 | B1 | 30 October 2024 |
| | | | | JP | 2023-515593 | A | 13 April 2023 |
| | | | | JP | 7396570 | B2 | 12 December 2023 |
| | | | | KR | 10-2764344 | B1 | 05 February 2025 |
| | | | | US | 2023-0273263 | A1 | 31 August 2023 |
| | | | | WO | 2022-071776 | A1 | 07 April 2022 |
| CN | 114814621 | A | 29 July 2022 | None | | | |

Form PCT/ISA/210 (patent family annex) (July 2022)